# EUROPEAN PATENT APPLICATION

(11) **EP 4 811 968 A1**
(43) Date of publication of application: **23.09.2026**
(21) Application number: 25200613.5
(22) Date of filing: 05.09.2025
(51) Int. Cl.: H10F 19/90, H10F 77/20

(54) **PHOTOVOLTAIC MODULE AND MANUFACTURING METHOD THEREOF**

(30) Priority: 19.03.2025 CN 202510330678
(71) Applicant: Zhejiang Jinko Solar Co., Ltd., Haining, Zhejiang 314416 (CN)
(72) Inventor: TAO, Wusong, HAINING, 314416 (CN); WANG, Luchuang, HAINING, 314416 (CN); HAN, Xiangchao, HAINING, 314416 (CN); CHANG, Liangyu, HAINING, 314416 (CN)
(74) Representative: Ipsilon

(57) **Abstract**

A photovoltaic module and a manufacturing thereof are provided. The photovoltaic module includes a cell string and solder ribbons. The cell string includes a plurality of cell pieces. The cell piece includes a cell piece body, a plurality of first gridlines, and a plurality of solder pad sets. The plurality of first gridlines are spaced apart on a target surface of the cell piece body. The solder pad sets are arranged in one-to-one correspondence on the first gridlines. The solder ribbons are arranged in one-to-one correspondence with the solder pad sets. The solder pad sets are electrically connected to each other by a corresponding solder ribbon. The first gridline includes two ends located at two opposite sides of the corresponding solder pad set in an extension direction of the first gridline. The solder ribbon is spaced apart from a target end of the corresponding first gridline.

## Description

### TECHNICAL FIELD

The present application relates to the field of photovoltaic technology, particularly relates to a photovoltaic module and a manufacturing method thereof.

### BACKGROUND

A photovoltaic module typically includes a plurality of cell pieces and solder ribbons, with two adjacent cell pieces electrically connected by the solder ribbons, thereby allowing the plurality of cell pieces to be connected to form a cell string.

However, the yield of photovoltaic module in related art is relatively low.

### SUMMARY

In view of this, to address the above technical issues, a photovoltaic module and a manufacturing method thereof are provided, which can reduce the breakage rate of the cell pieces of the photovoltaic module and thus improve the yield of the photovoltaic module.

According to a first aspect of the present application, a photovoltaic module is provided, which includes a cell string and solder ribbons. The cell string includes a plurality of cell pieces. At least one of the cell pieces includes a cell piece body, a plurality of first gridlines, and a plurality of solder pad sets. The cell piece body has a first surface and a second surface opposite to each other in a thickness direction of the cell piece body. At least one of the first surface and the second surface is defined as a target surface. The plurality of first gridlines are spaced apart from each other on the target surface of the cell piece body. The solder pad sets are arranged in one-to-one correspondence on the first gridlines. The solder ribbons are arranged in one-to-one correspondence with the solder pad sets. The solder pad sets of two adjacent cell pieces are electrically connected to each other by the corresponding solder ribbon. The first gridline includes two ends located at two opposite sides of the corresponding solder pad set in an extension direction of the first gridline. In two adjacent cell pieces, one end of the two ends of one cell piece, which is located adjacent to another cell piece, is defined as a target end. At least one of the solder ribbons is spaced apart from the target end of a corresponding first gridline in a thickness direction of the cell piece body.

In an embodiment, a space between the solder ribbon and the target end of the corresponding first gridline in the thickness direction of the cell piece body is in a range from 10 µm to 500 µm.

In an embodiment, a size of the target end in a direction oriented from one of the two adjacent cell pieces to another one of the two adjacent cell pieces is in a range from 3 mm to 10 mm.

In an embodiment, the photovoltaic module further includes a spacing layer. The spacing layer is provided on the target surface of at least one of two adjacent cell pieces to cover the target end. The cell piece of two adjacent cell pieces that is provided with the spacing layer is defined as a target cell piece, and a portion of the solder ribbon is located on a side of the spacing layer facing away from the target cell piece.

In an embodiment, a thickness of the spacing layer is in a range from 10 µm to 500 µm; and/or
a size of the spacing layer in a direction oriented from one of the two adjacent cell pieces to another one of the two adjacent cell pieces is in a range from 3 mm to 10 mm.

In an embodiment, at least one of the solder pad sets includes a plurality of solder pads spaced apart from each other in an extension direction of the first gridline. In the direction oriented from one of the two adjacent cell pieces to another one of the two adjacent cell pieces, the spacing layer is spaced apart from an adjacent solder pad, and a space between the spacing layer and the adjacent solder pad is defined as L, where 0 mm<L≤2 mm.

In an embodiment, a material of the spacing layer includes an insulating material; and/or
the spacing layer is elastic.

In an embodiment, at least one of the solder pad sets includes a plurality of solder pads spaced apart from each other in the extension direction of the first gridline. In a direction oriented from one of two adjacent cell pieces to another one of the two adjacent cell pieces, the cell piece has two edge portions opposite to each other. In the direction oriented from one of the two adjacent cell pieces to another one of the two adjacent cell pieces, a space between the edge portion and the adjacent solder pad is in a range from 2 mm to 12 mm.

According to a second aspect of the present application, a method for manufacturing a photovoltaic module is provided, which includes: providing a cell string including a plurality of cell pieces; wherein at least one of the cell pieces includes a cell piece body, a plurality of first gridlines, and a plurality of solder pad sets; in a thickness direction of the cell piece body, the cell piece body has a first surface and a second surface opposite to each other, and at least one of the first surface and the second surface is defined as a target surface; the plurality of first gridlines are spaced apart from each other on the target surface of the cell piece body, the solder pad sets are arranged in one-to-one correspondence on the first gridlines; at least one of the first gridlines includes two ends located at two opposite sides of the corresponding solder pad set in an extension direction of the first gridline; in two adjacent cell pieces, one end of the two ends of one cell piece, which is located adjacent to another cell piece, is defined as a target end; and electrically connecting the solder pad sets of two adjacent cell pieces to each other by corresponding solder ribbons, with at least one of the solder ribbons being spaced apart from the target end of the corresponding first gridline in the thickness direction of the cell piece body.

In an embodiment, prior to electrically connecting the solder pad sets of the two adjacent cell pieces to each other by the corresponding solder ribbons, with at least one of the solder ribbons being spaced apart from the target end of the corresponding first gridline in the thickness direction of the cell piece body, the method further includes: forming a spacing layer on the target surface of at least one of two adjacent cell pieces to cover the target end.

In the technical solutions of the present application, spacing the solder ribbon apart from the target end of the corresponding first gridline is conducive to reducing the risk of soldering the solder ribbon to the target end of the corresponding first grid line, thereby reducing the likelihood of the section of the solder ribbon corresponding to the target end being soldered, and increasing the movement margin of the solder ribbon at the joint between the two adjacent cell pieces. Consequently, the increased risk of the cell piece breakage due to the solder ribbon being soldered at the edge of the first gridline can be prevented, which is conducive to reducing the breakage rate of the cell pieces of the photovoltaic module to a certain extent, thereby improving the yield of the photovoltaic module.

### BRIEF DESCRIPTION OF THE DRAWINGS

FIG. 1 shows a schematic structural view of a cell piece according to an embodiment of the present application.
FIG. 2 shows a schematic structural view of a photovoltaic module according to an embodiment of the present application.
FIG. 3 shows a partial schematic structural view of the cell piece, a solder ribbon, and a spacing layer according to an embodiment of the present application.

Reference Numerals: 100, cell piece; 110, cell piece body; 101, edge portion; 120, first gridline; 121, end; 130, solder pad set; 131, solder pad; 140, edge gridline; 150, second gridline; 200, solder ribbon; 300, spacing layer.

### DETAILED DESCRIPTION

To make the objectives, features, and advantages of the present application more apparent and understandable, specific embodiments of the present application will be described in detail below in conjunction with accompanying drawings. Many specific details are disclosed in the following description to facilitate a comprehensive understanding of the present application. However, the present application can be implemented in various ways different from those described herein, and those skilled in the art may make similar improvements without departing from the scope of the present application. Therefore, the present application is not limited to the specific embodiments disclosed below.

In the description of the present application, it should be understood that the orientation or position relationships indicated by the terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present application and simplify the description only, rather than indicating or implying that the devices or elements referred to must have a particular orientation or be constructed or operated in a particular orientation, and therefore are not to be interpreted as limiting the present application.

In addition, the terms "first" and "second" are merely used for descriptive purposes, and should not be construed as indicating or implying relative importance or implying the quantity of the described technical features. Therefore, the features defined with "first" or "second" may explicitly or implicitly include at least one of the features. In the description of the present application, "a plurality of" means at least two, such as two, three, etc., unless otherwise expressly and specifically defined.

In the present application, unless otherwise specified and defined explicitly, the terms "install", "connect", "couple", "fix" and the like should be understood in a broad sense. For example, unless otherwise defined explicitly, they may refer to a fixed connection, a detachable connection, or an integral connection, may refer to a mechanical connection or an electrical connection, and may refer to a direct connection, an indirect connection via an intermediate medium, an internal communication between two elements, or interaction between two elements. The specific meanings of these terms in the present application can be understood based on specific circumstances by those of ordinary skills in the art.

In the present application, unless otherwise specified and defined explicitly, a first feature, when expressed as being "on" or "under" a second feature, may be in direct contact with the second feature or in indirect contact with the second feature via an intermediate medium. Furthermore, a first feature, when expressed as being "over", "above" or "on top of" a second feature, may be located right above or obliquely above the second feature, or only located at a level higher than that of the second feature. A first feature, when expressed as being "below", "underneath" or "under" a second feature, may be located right below or obliquely below the second feature, or only located at a level lower than that of the second feature.

It should be noted that when an element is referred to as being "fixed to" or "arranged on" another element, it may be provided on the other element directly or an intermediate element may exist. When an element is referred to as being "connected to" another element, it may be connected to the other element directly or an intermediate element may coexist. Such terms as "vertical", "horizontal", "upper", "lower", "left", "right" and similar expressions used in the present application are for illustrative purposes only and are not intended to represent the only implementation.

A photovoltaic module typically includes a plurality of cell pieces and solder ribbons, where two adjacent cell pieces are electrically connected by the solder ribbons, thereby allowing the plurality of cell pieces to be connected to form a cell string.

However, in the photovoltaic module in related art, the solder ribbons tend to be soldered at the edges of the gridlines of the cell pieces, leading to a high breakage rate of cell pieces of the photovoltaic module, which in turn results in a low yield of the photovoltaic module in related art.

To address the above-mentioned technical issues, the present application designs a photovoltaic module that can reduce the occurrence of the solder ribbons being soldered at the edges of first gridlines of the cell pieces, thereby reducing the breakage rate of the cell pieces of the photovoltaic module and thus improving the yield of the photovoltaic module.

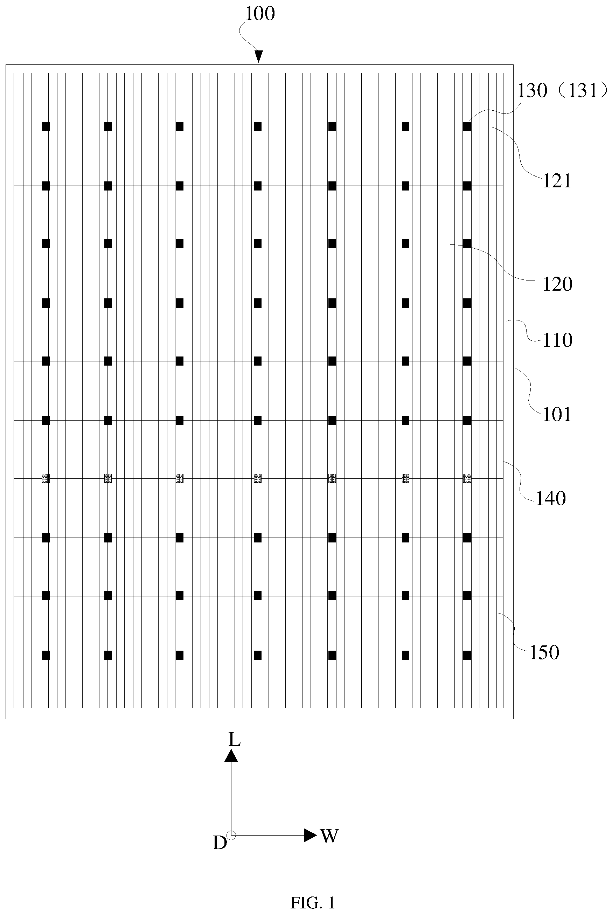

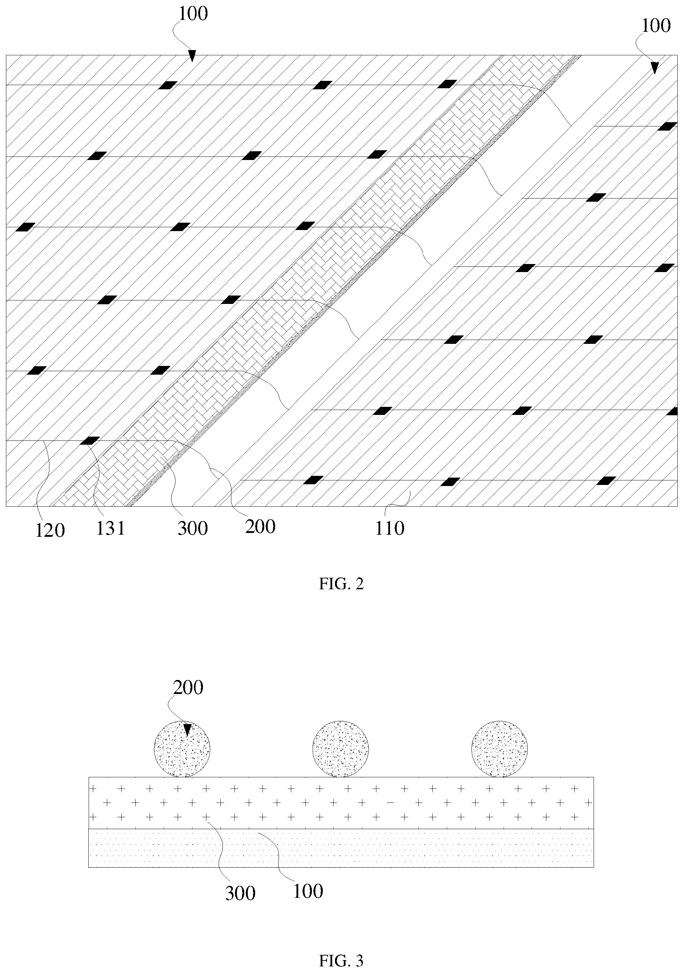

FIG. 1 shows a schematic structural view of a cell piece according to an embodiment of the present application. FIG. 2 shows a schematic structural view of a photovoltaic module according to an embodiment of the present application. FIG. 3 shows a partial schematic structural view of the cell piece, a solder ribbon, and a spacing layer according to an embodiment of the present application.

Referring to FIGS. 1 to 3, an embodiment of the present application provides a photovoltaic module, which includes a cell string and solder ribbons 200. The cell string includes a plurality of cell pieces 100. The cell piece 100 includes a cell piece body 110, a plurality of first gridlines 120, and a plurality of solder pad sets 130. In a thickness direction of the cell piece body 110, the cell piece body 110 has a first surface and a second surface opposite to each other. At least one of the first surface and the second surface is defined as a target surface. That is, the first surface can be the target surface; alternatively, the second surface can be the target surface; and yet alternatively, each of the first surface and the second surface can be the target surface.

The plurality of first gridlines 120 are spaced apart from each other on the target surface of the cell piece body 110. The solder pad sets 130 are arranged in one-to-one correspondence on the first gridlines 120. The solder ribbons 200 are arranged in one-to-one correspondence with the solder pad sets 130. The solder pad sets 130 of two adjacent cell pieces 100 are electrically connected to each other by corresponding solder ribbons 200.

Each solder pad set130 includes a plurality of solder pads 131 spaced apart from each other in an extension direction of the first gridline 120.

The first gridlines 120 can extend longitudinally in a length direction L of the cell piece body 110, or the first gridlines 120 can extend longitudinally in a width direction W of the cell piece body 110, which is not specifically limited herein. The length direction L of the cell piece body 110, the width direction W of the cell piece body 110, and the thickness direction D of the cell piece body 110 are perpendicular to each other.

The expression "the solder pad sets 130 of two adjacent cell pieces 100 are electrically connected to each other by corresponding solder ribbons 200" means that: in the two adjacent cell pieces 100, at least a part of the solder pads 131 in the solder pad set 130 of one cell piece 100 is electrically connected to the corresponding solder ribbons 200, while at least a part of the solder pads 131 in the solder pad set 130 of the other cell piece 100 is electrically connected to the corresponding solder ribbons 200. That is, a part of the solder pads 131 in the solder pad set 130 of one of the two adjacent cell pieces 100 can be electrically connected to the corresponding solder ribbons 200, or all solder pads 131 in the solder pad set 130 of one of the two adjacent cell pieces 100 can be electrically connected to the corresponding solder ribbons 200, which is not specifically limited herein.

Since the solder pad sets 130 of two adjacent cell pieces 100 are electrically connected to each other by the corresponding solder ribbons 200, the two adjacent cell pieces 100 can be connected in series by the corresponding solder ribbons 200. In this way, the plurality of cell pieces 100 can be connected in series to form the cell string.

In addition, as the plurality of first gridlines 120 are spaced apart from each other, and the first gridlines 120 extend longitudinally in the length direction L of the cell piece body 110 or in the width direction W of the cell piece body 110, the first gridlines 120 are not arranged in a harpoon structure, preventing excessive thickness at the ends 121 of the first gridlines 120, which may occur in the harpoon structure, thereby reducing the breakage probability of the cell pieces.

The first gridline 120 includes two ends 121. The two ends 121 are located at two opposite sides of a corresponding solder pad set 130 in the extension direction of the first gridline 120. In two adjacent cell pieces 100, one end 121 of the two ends 121 of one cell piece 100, which is located more adjacent to the other cell piece 100, is defined as a target end. The solder ribbon 200 is spaced apart from the target end of the corresponding first gridline 120 in the thickness direction of the cell piece body 110.

Optionally, before soldering the solder pad set 130 to the corresponding solder ribbon 200, a temporary component is temporarily provided at the target end to space the solder ribbon 200 apart from the target end of the corresponding first gridline 120, and the temporary component is removed after soldering. Alternatively, before soldering the solder pad set 130 to the corresponding solder ribbon 200, a component such as a spacing layer 300 as described below is provided at the target end to space the solder ribbon 200 apart from the target end of the corresponding first gridline 120, with the spacing layer 300 being retained after soldering. Certainly, the solder ribbon 200 can be spaced apart from the target end of the corresponding first gridline 120 by other ways, which are not specifically limited herein.

Spacing the solder ribbon 200 apart from the target end of the corresponding first gridline 120 is conducive to reducing the risk of soldering the solder ribbon 200 to the target end of the corresponding first grid line 120, thereby reducing the likelihood of the section of the solder ribbon 200 corresponding to the target end being soldered, and increasing the movement margin of the solder ribbon 200 at the joint between the two adjacent cell pieces 100. Consequently, the increased risk of the cell piece breakage due to the solder ribbon 200 being soldered at the edge of the first gridline 120 can be prevented, which is conducive to reducing the breakage rate of the cell pieces of the photovoltaic module to a certain extent, thereby improving the yield of the photovoltaic module. If the solder ribbon 200 is soldered at the edge of the first gridline 120, the thickness at an edge of the cell piece 100 is excessively high, thereby resulting in increased breakage risk of the cell pieces.

In some embodiments, a space between the solder ribbon 200 and the target end of the corresponding first gridline 120 in the thickness direction of the cell piece body 110 is in a range from 10 µm to 500 µm.

For example, the space between the solder ribbon 200 and the target end of the corresponding first gridline 120 in the thickness direction of the cell piece body 110 is 10 µm, 100 µm, 200 µm, 300 µm, 400 µm, or 500 µm _{∘}

If the space between the solder ribbon 200 and the target end of the corresponding first gridline 120 in the thickness direction of the cell piece body 110 is too small, the risk of the section of the solder ribbon 200 corresponding to the target end being soldered can be increased. If the space between the solder ribbon 200 and the target end of the corresponding first gridline 120 in the thickness direction of the cell piece body 110 is too large, the thickness at the edge of the cell piece 100 is too large, which in turn increases the breakage risk of the cell pieces. Thus, by setting the space between the solder ribbon 200 and the target end of the corresponding first gridline 120 in the thickness direction of the cell piece body 110 in an appropriate range, i.e., in the range from 10 µm and 500 µm, not only the risk of the section of the solder ribbon 200 corresponding to the target end being soldered can be reduced, but also the thickness at the edge of the cell piece 100 can be controlled in an appropriate range, thereby reducing the breakage risk of the cell pieces and improving the yield of the photovoltaic module.

In some embodiments, a size of the target end in a direction oriented from one of two adjacent cell pieces 100 to the other of the two adjacent cell pieces 100 is in a range from 3 mm to 10 mm.

The size of the target end in the direction oriented from one of two adjacent cell pieces 100 to the other of the two adjacent cell pieces 100 is a width of the target end.

For example, the width of the target end is 3 mm, 4 mm, 5 mm, 6 mm, 7 mm, 8 mm, 9 mm, or 10 mm.

If the width of the target end is too small, the risk of the section of the solder ribbon 200 corresponding to the target end being soldered is increased. If the width of the target end is too large, the plurality of solder pads 131 of the solder pad set 130 are distributed too densely, thereby increasing the difficulty of soldering the solder pad set 130 to the solder ribbon 200. Thus, the width of the target end needs to be set in an appropriate range, for example, in a range from 3 mm to 10 mm, which not only can reduce the risk of the section of the solder ribbon 200 corresponding to the target end being soldered, but also can facilitate the soldering of the plurality of solder pads 131 of the solder pad set 130 to the corresponding solder ribbon 200.

In some embodiments, the photovoltaic module further includes a spacing layer 300. The spacing layer 300 is provided on the target surface of at least one of the two adjacent cell pieces to cover the target end. The cell piece 100 of two adjacent cell pieces 100 that is provided with the spacing layer 300 is defined as a target cell piece. A portion of the solder ribbon 200 is located on a side of the spacing layer 300 facing away from the target cell piece.

It should be understood that, in the direction oriented from one of two adjacent cell pieces 100 to the other of the two adjacent cell pieces 100, the spacing layer 300 is located on a side of the solder pad set 130 on the target cell piece adjacent to the other of the two adjacent cell pieces 100.

By using the spacing layer 300, the solder ribbon 200 can be effectively spaced apart from the target end of the corresponding first gridline 120, thereby preventing the increased risk of the cell piece breakage due to the solder ribbon 200 being soldered at the edge of the first gridline 120, which reduces the breakage rate of the cell pieces of the photovoltaic module to a certain extent and improves the yield of the photovoltaic module.

In some embodiments, a thickness of the spacing layer 300 is in a range from 10 µm to 500 µm.

For example, the thickness of the spacing layer 300 is 10 µm, 50 µm, 100 µm, 200 µm, 300 µm, 400 µm, or 500 µm.

If the thickness of the spacing layer 300 is too small, the difficulty of the process for preparing the spacing layer 300 is increased. If the thickness of the spacing layer 300 is too large, the thickness of the cell piece 100 at the edge thereof is too large, which tends to increase breakage risk of the cell pieces. Thus, the thickness of the spacing layer 300 needs to be set in an appropriate range, that is, the thickness of the spacing layer 300 is set in a range from 10 µm to 500 µm, which not only can reduce the risk of the section of the solder ribbon 200 corresponding to the target end being soldered, but also can control the thickness of the cell piece 100 at the edge thereof within an appropriate range, thereby decreasing the breakage risk of the cell pieces and thus improving the yield of the photovoltaic module.

In some embodiments, a size of the spacing layer 300 in the direction oriented from one of two adjacent cell pieces 100 to the other of the two adjacent cell pieces 100 is in a range from 3 mm to 10 mm.

The size of the spacing layer 300 in the direction oriented from one of two adjacent cell pieces 100 to the other of the two adjacent cell pieces 100 is a width of the spacing layer 300.

For example, the width of the spacing layer 300 is 3 mm, 4 mm, 5 mm, 6 mm, 7 mm, 8 mm, 9 mm, or 10 mm.

If the width of the spacing layer 300 is too small, the risk of the solder ribbon 200 being soldered at the edge of the first gridline 120 increases. If the width of the spacing layer 300 is too large, the spacing layer 300 is likely to cover the solder pad set 130, which increases the probability of the soldering failure for the outermost solder pad 131 in the solder pad set 130. Thus, the width of the spacing layer 300 needs to be set in an appropriate range, for example, the width of the spacing layer 300 is set in a range from 3 mm to 10 mm, which not only can reduce the risk of the solder ribbon 200 being soldered at the edge of the first gridline 120, thereby decreasing the breakage risk of the cell pieces, but also can allow the solder pads 131 in the solder pad set 130 to be firmly soldered to the corresponding solder ribbon 200, thereby increasing the yield of the photovoltaic module.

In some embodiments, in the direction oriented from one of two adjacent cell pieces 100 to the other of the two adjacent cell pieces 100, the spacing layer 300 is spaced apart from the adjacent solder pad 131, and a space between the spacing layer 300 and the adjacent solder pad 131 is defined as L, where 0 mm<L≤2 mm.

For example, the space between the spacing layer 300 and the adjacent solder pad 131 is 0.1 mm, 0.5 mm, 1 mm, or 2 mm.

If the space between the spacing layer 300 and the adjacent solder pad 131 is too small, for example, the space between the spacing layer 300 and the adjacent solder pad 131 is zero, the probability of the soldering failure for the outermost solder pad 131 in the solder pad set 130 increases. If the space between the spacing layer 300 and the adjacent solder pad 131 is too large, the risk of the solder ribbon 200 being soldered at the edge of the first gridline 120 increases.

Thus, the space between the spacing layer 300 and the adjacent solder pad 131 needs to be set in an appropriate range, such as in a range of 0 mm<L≤2 mm, which not only can effectively reduce the risk of the solder ribbon 200 being soldered at the edge of the first gridline 120, thereby reducing the breakage risk of the cell pieces, but also can allow the solder pads 131 in the solder pad set 130 to be firmly soldered to the corresponding solder ribbon 200, thereby increasing the yield of the photovoltaic module.

Optionally, in the direction oriented from one of two adjacent cell pieces 100 to the other of the two adjacent cell pieces 100, a side of the spacing layer 300 away from the adjacent solder pad 131 is aligned with an edge portion 101 of the cell piece 100.

In some embodiments, a material of the spacing layer 300 includes an insulating material.

As such, the probability of the solder ribbon 200 being soldered onto the spacing layer 300 can be reduced, thereby improving the reliability and yield of the photovoltaic module.

In some embodiments, the spacing layer 300 can be elastic.

The elastic spacing layer 300 can enhance the impact resistance of the cell piece 100, thereby reducing the breakage risk of the cell pieces and improving the yield of the photovoltaic module.

In some embodiments, a material of the spacing layer 300 includes an insulating material, and the spacing layer 300 is elastic.

For example, the material of the spacing layer 300 includes one or more of ethylene-vinyl acetate copolymer (EVA), polyolefin elastomer (POE), expanded polyethylene (EPE), polyvinyl butyral (PVB), polyethylene terephthalate (PET), polyvinyl chloride (PVC), thermoplastic polyurethane elastomer (TPU), polycarbonate (PC), or polyvinylidene difluoride (PVDF).

In some embodiments, each solder pad set 130 includes a plurality of solder pads 131 spaced apart from each other in the extension direction of the first gridline 120. In the direction oriented from one of two adjacent cell pieces 100 to the other of the two adjacent cell pieces 100, the cell piece 100 has two edge portions 101 opposite to each other. In the direction oriented from one of two adjacent cell pieces 100 to the other of the two adjacent cell pieces 100, a space between the edge portion 101 and the adjacent solder pad 131 is in a range from 2 mm to 12 mm.

For example, in the direction oriented from one of two adjacent cell pieces 100 to the other of the two adjacent cell pieces 100, the space between the edge portion 101 and the adjacent solder pad 131 is 2 mm, 4 mm, 6 mm, 8 mm, 10 mm, or 12 mm.

If the space between the edge portion 101 and the adjacent solder pad 131 is too narrow, the target end located at an outer side of the solder pad set 130 is too narrow, thereby resulting in the risk of the solder ribbon 200 being soldered at the edge of the first gridline 120. If the space between the edge portion 101 and the adjacent solder pad 131 is too wide, the movement margin of the solder ribbon 200 is too much, thereby increasing the risk of soldering failure. Thus, the space between the edge portion 101 and the adjacent solder pad 131 needs to be set within an appropriate range, such as in a range from 2 mm to 12 mm, which not only can effectively reduce the risk of the solder ribbon 200 being soldered at the edge of the first gridline 120, thereby reducing the breakage risk of the cell pieces, but also can allow the solder pads 131 in the solder pad set 130 to be firmly soldered to the corresponding solder ribbon 200, thereby increasing the yield of the photovoltaic module.

In some embodiments, the cell piece 100 further includes two edge gridlines 140 and a plurality of second gridlines 150 disposed on the target surface. One of the edge gridlines 140 is electrically connected to one end of each of the first gridlines 120 on the target surface. The other of the edge gridlines 140 is electrically connected to the other end of each of the first gridlines 120 on the target surface. The plurality of first gridlines 120 are spaced apart from each other in one of the length direction L of the cell piece 100 and the width direction W of the cell piece 100. The plurality of second gridlines 150 are spaced apart from each other in the other of the length direction L of the cell piece 100 and the width direction W of the cell piece 100. The second gridlines 150 are electrically connected to the first gridlines 120. The second gridlines 150 are electrically connected to the cell piece body 110.

It should be understood that the first gridlines 120 can be electrically connected to the cell piece body 110.

For example, the plurality of first gridlines 120 are spaced apart from each other in the length direction L of the cell piece 100, while the plurality of second gridlines 150 are spaced apart from each other in the width direction W of the cell piece 100.

Both the edge gridlines 140 and the first gridlines 120 are busbars. The second gridlines 150 are fingers. During the operation of the photovoltaic module, the plurality of second gridlines 150 can collect electric currents generated due to the photovoltaic effect, and the plurality of first gridlines 120 can collect the electric currents collected by the plurality of second gridlines 150 and then output the collected currents.

The cell piece 100 of the photovoltaic module can be a back contact cell (BC), a tunneling oxide passivated contact solar cell (TOPCon), a passivated emitter and rear cell (PERC), a heterojunction with intrinsic thin-layer cell (HJT), etc.

The gridlines of the tunneling oxide passivated contact solar cell (TOPCon), the passivated emitter and rear cell (PERC), or the heterojunction with intrinsic thin-layer cell (HJT) can include the first gridlines 120, the edge gridlines 140, and the second gridlines 150 as described above. In some other embodiments, when the cell piece 100 of the photovoltaic module is a back contact cell, i.e., the photovoltaic module is a back contact photovoltaic module, the first surface of the cell piece 100 is a front surface, the second surface of the cell piece 100 is a back surface, and a plurality of first gridlines 120 and a plurality of second gridlines 150 (not shown) are arranged on the back surface of the cell piece 100. The first gridlines 120 serve as busbars, while the second gridlines 150 serve as fingers. The plurality of first gridlines 120 on the back surface of the cell piece 100 include a plurality first sub-gridlines and a plurality of second sub-gridlines arranged alternately. Each of the first sub-gridline and the second sub-gridline has two ends 121. The plurality of second gridlines 150 on the back surface of the cell piece 100 include a plurality of third sub-gridlines and a plurality of fourth sub-gridlines spaced apart from each other. The first sub-gridline and the third sub-gridline are perpendicular to each other and are both parallel to the back surface. Each first sub-gridline is electrically connected to the third sub-gridlines adjacent thereto. As such, all first sub-gridlines can be configured to collect electric currents collected by all third sub-gridlines. The second sub-gridline and the fourth sub-gridline are perpendicular to each other and are both parallel to the back surface. Each second sub-gridline is electrically connected to the fourth sub-gridlines adjacent thereto. As such, all second sub-gridlines can be configured to collect electric currents collected by all fourth sub-gridlines. A plurality of solder ribbon 200 includes a first solder ribbon corresponding to the first sub-gridline and a second solder ribbon corresponding to the second sub-gridline. As such, in the thickness direction of the cell piece body 110, the first solder ribbon is spaced apart from the target end of the corresponding first sub-gridline, and the second solder ribbon is spaced apart from the target end of the corresponding second sub-gridline.

An embodiment of the present application further provides a method for manufacturing a photovoltaic module, including the following steps:

S11, providing a cell string including a plurality of cell pieces 100, wherein the cell piece 100 includes a cell piece body 110, a plurality of first gridlines 120, and a plurality of solder pad sets 130; in a thickness direction of the cell piece body 110, the cell piece body 110 has a first surface and a second surface opposite to each other, with at least one of the first surface and the second surface being defined as a target surface; the plurality of first gridlines 120 are spaced apart on the target surface of the cell piece body 110, and the solder pad sets 130 are arranged in one-to-one correspondence on the first gridlines 120; at least one of the first gridlines 120 includes two ends 121, and the two ends 121 are located at two opposite sides of a corresponding solder pad set 130 in an extension direction of the first gridline 120; and

S20, electrically connecting the solder pad sets 130 of two adjacent cell pieces 100 by a corresponding solder ribbon 200, with the solder ribbon 200 being spaced apart from a target end of the corresponding first gridline 120 in the thickness direction of the cell piece body 110.

In this way, the risk of the section of the solder ribbon 200 corresponding to the target end being soldered can be reduced, so that the movement margin of the solder ribbon 200 at the joint between the two adjacent cell pieces 100 can be increased, which helps to prevent an increased risk of the cell piece breakage due to the solder ribbon 200 being soldered at the edge of the first gridline 120, reducing the breakage rate of the cell pieces of the photovoltaic module to a certain extent, thus improving the yield of the photovoltaic module.

Optionally, before step S20, the method for manufacturing the photovoltaic module further includes:

S12, forming a spacing layer 300 on the target surface of at least one of two adjacent cell pieces 100 to cover the target end.

By using the spacing layer 300, the solder ribbon 200 can be effectively spaced apart from the target end of the corresponding first gridline 120, which prevents the increased risk of the cell piece breakage due to the solder ribbon 200 being soldered at the edge of the first gridline 120, reducing the breakage rate of the cell pieces of the photovoltaic module to a certain extent, thus improving the yield of the photovoltaic module.

## Claims

1. A photovoltaic module (100), comprising:
a cell string comprising a plurality of cell pieces (100), at least one of the cell pieces (100) comprising:
a cell piece body (110) having a first surface and a second surface opposite to each other in a thickness direction of the cell piece body (110), with at least one of the first surface and the second surface being defined as a target surface;
a plurality of first gridlines (120) spaced apart from each other on the target surface of the cell piece body (110); and
a plurality of solder pad sets (130) arranged in one-to-one correspondence on the first gridlines (120); and
solder ribbons (200) arranged in one-to-one correspondence with the solder pad sets (130), with the solder pad sets (130) of two adjacent cell pieces (100) being electrically connected to each other by corresponding solder ribbons (200);
wherein at least one of the first gridlines (120) comprises two ends (121) located at two opposite sides of a corresponding solder pad set (130) in an extension direction of the first gridline (120);
in the two adjacent cell pieces (100), one end (121) of the two ends (121) of one cell piece (100), which is located adjacent to another cell piece (100), is defined as a target end (121);
at least one of the solder ribbons (200) is spaced apart from the target end (121) of a corresponding first gridline (120) in a thickness direction of the cell piece body (110).

2. The photovoltaic module (100) of claim 1, wherein a space between the solder ribbon (200) and the target end (121) of the corresponding first gridline (120) in the thickness direction of the cell piece body (110) is in a range from 10 µm to 500 µm.

3. The photovoltaic module (100) of claim 1 or 2, wherein a size of the target end (121) in a direction oriented from one of the two adjacent cell pieces (100) to another one of the two adjacent cell pieces (100) is in a range from 3 mm to 10 mm.

4. The photovoltaic module (100) of any one of claims 1 to 3, further comprising a spacing layer (300),
wherein the spacing layer (300) is provided on the target surface of at least one of the two adjacent cell pieces (100) to cover the target end (121);
a cell piece (100) of two adjacent cell pieces (100) that is provided with the spacing layer (300) is defined as a target cell piece (100), and a portion of the solder ribbon (200) is located on a side of the spacing layer (300) facing away from the target cell piece (100).

5. The photovoltaic module (100) of claim 4, wherein a thickness of the spacing layer (300) is in a range from 10 µm to 500 µm; and/or
a size of the spacing layer (300) in a direction oriented from one of the two adjacent cell pieces (100) to another one of the two adjacent cell pieces (100) is in a range from 3 mm to 10 mm.

6. The photovoltaic module (100) of claim 4 or 5, wherein at least one of the solder pad sets (130) comprises a plurality of solder pads (131) spaced apart from each other in an extension direction of the first gridline (120);
in the direction oriented from one of the two adjacent cell pieces (100) to another one of the two adjacent cell pieces (100), the spacing layer (300) is spaced apart from an adjacent solder pad (131), and a space between the spacing layer (300) and the adjacent solder pad (131) is defined as L, where 0 mm<L≤2 mm.

7. The photovoltaic module (100) of any one of claims 4 to 6, wherein a material of the spacing layer (300) comprises an insulating material, and/or
the spacing layer (300) is elastic, and/or
a material of the spacing layer (300) comprises one or more of ethylene-vinyl acetate copolymer, polyolefin elastomer, expanded polyethylene, polyvinyl butyral, polyethylene terephthalate, polyvinyl chloride, thermoplastic polyurethane elastomer, polycarbonate, or polyvinylidene difluoride.

8. The photovoltaic module (100) of any one of claims 1 to 7, wherein at least one of the solder pad sets (130) comprises a plurality of solder pads (131) spaced apart from each other in the extension direction of the first gridline (120);
in a direction oriented from one of two adjacent cell pieces (100) to another one of the two adjacent cell pieces (100), the cell piece (100) has two edge portions (101) opposite to each other;
in the direction oriented from one of the two adjacent cell pieces (100) to another one of the two adjacent cell pieces (100), a space between the edge portion (101) and an adjacent solder pad (131) is in a range from 2 mm to 12 mm.

9. The photovoltaic module (100) of claim 6, wherein at least one of the solder pad sets (130) comprises a plurality of solder pads (131) spaced apart from each other in the extension direction of the first gridline (120);
in a direction oriented from one of two adjacent cell pieces (100) to another one of the two adjacent cell pieces (100), the cell piece (100) has two edge portions (101) opposite to each other;
in the direction oriented from one of the two adjacent cell pieces (100) to another one of the two adjacent cell pieces (100), a space between the edge portion (101) and an adjacent solder pad (131) is in a range from 2 mm to 12 mm;
optionally in the direction oriented from one of the two adjacent cell pieces (100) to another one of the two adjacent cell pieces (100), a side of the spacing layer (300) away from the adjacent solder pad (131) is aligned with an edge portion (101) of the cell piece (100).

10. The photovoltaic module (100) of any one of claims 1 to 9, wherein the cell piece (100) further comprises two edge gridlines (140) disposed on the target surface, one of the edge gridlines (140) is electrically connected to one end (121) of at least one of the first gridlines (120) on the target surface, and another one of the edge gridlines (140) is electrically connected to another end (121) of at least one of the first gridlines (120) on the target surface.

11. The photovoltaic module (100) of any one of claims 1 to 10, wherein the cell piece (100) further comprises a plurality of second gridlines (150) spaced apart from each other on the target surface, optionally the second gridlines (150) are perpendicular to the first gridlines (120).

12. The photovoltaic module (100) of claim 6, wherein the spacing layer (300) is located on a side of the solder pad set (130) on the target cell piece (100) adjacent to another cell piece (100) of the two adjacent cell pieces (100).

13. The photovoltaic module (100) of any one of claims 1 to 12, wherein the cell piece (100) is at least one selected from the group consisting of a back contact cell, a tunneling oxide passivated contact solar cell, a passivated emitter and rear cell, and a heterojunction with intrinsic thin-layer cell.

14. A method for manufacturing a photovoltaic module (100), comprising:
providing a cell string comprising a plurality of cell pieces (100); wherein at least one of the cell pieces (100) comprises a cell piece body (110), a plurality of first gridlines (120), and a plurality of solder pad sets (130); in a thickness direction of the cell piece body (110), the cell piece body (110) has a first surface and a second surface opposite to each other, and at least one of the first surface and the second surface is defined as a target surface; the plurality of first gridlines (120) are spaced apart from each other on the target surface of the cell piece body (110), the solder pad sets (130) are arranged in one-to-one correspondence on the first gridlines (120); at least one of the first gridlines (120) comprises two ends (121) located at two opposite sides of a corresponding solder pad set (130) in an extension direction of the first gridline (120); in two adjacent cell pieces (100), one end (121) of the two ends (121) of one cell piece (100), which is located adjacent to another cell piece (100), is defined as a target end (121); and electrically connecting the solder pad sets (130) of the two adjacent cell pieces (100) to each other by corresponding solder ribbons (200), with at least one of the solder ribbons (200) being spaced apart from the target end (121) of the corresponding first gridline (120) in the thickness direction of the cell piece body (110).

15. The method of claim 14, prior to electrically connecting the solder pad sets (130) of the two adjacent cell pieces (100) to each other by the corresponding solder ribbons (200), with at least one of the solder ribbons (200) being spaced apart from the target end (121) of the corresponding first gridline (120) in the thickness direction of the cell piece body (110), further comprising:
forming a spacing layer (300) on the target surface of at least one of the two adjacent cell pieces (100) to cover the target end (121).
